# EUROPÄISCHE PATENTSCHRIFT

(11) **EP 3 312 252 B1**
(45) Veröffentlichungstag und Bekanntmachung des Hinweises auf die Patenterteilung: **11.08.2021**
(21) Anmeldenummer: 17197436.3
(22) Anmeldetag: 20.10.2017
(51) Int. Cl.: C09J 7/20, C09J 5/02, B32B 7/12, B32B 37/26, B32B 38/00, H01B 7/02

(54) **PLASMABEHANDLUNG EINER MEHRLAGENVERKLEBUNG**
PLASMA TREATMENT OF A MULTI-LAYER ADHESIVE
TRAITEMENT PAR PLASMA D'UN CORPS ADHÉSIF MULTICOUCHE

(30) Priorität: 21.10.2016 DE 102016220687
(43) Veröffentlichungstag der Anmeldung: 25.04.2018
(73) Patentinhaber: tesa SE, 22848 Norderstedt (DE)
(72) Erfinder: Hähnel, Marcel, 25336 Klein Nordende (DE); Kipke, Jennifer, 20257 Hamburg (DE); Nagel, Christoph, 22417 Hamburg (DE); Sellin, Jannik, 22767 Hamburg (DE)
(74) Vertreter: tesa SE

(56) Entgegenhaltungen:
- EP-A2- 1 498 910
- DE-A1-102014 222 723
- US-A- 5 106 383

## Beschreibung

Die Erfindung betrifft ein Verfahren zum umwickelnden Verkleben von einem sich in einem Wicklungsquerschnitt ausdehnenden Medium mit einem Klebeband. Die Erfindung betrifft auch eine Einrichtung mit einem auf sich selbst gewickelten Klebeband.

Es ist eine Reihe von Applikationen von Klebebändern bekannt, bei der die Klebebänder um ein Medium mehrfach auf sich selbst gewickelt werden. Beispielsweise bei der Herstellung von Hochvoltspeichern werden Klebebänder mehrlagig auf sich selbst verklebt und gewickelt. Zum einen durch die Vorspannung bei der Wicklung selbst, aber auch durch einen Ausdehnungsprozess während der Lade- und Entladevorgänge der Batterien wird eine Kraft auf den Wicklungsverbund ausgeübt. In einigen Applikationen können die Klebebänder durch Filamente verstärkt sein. Die Filamente verlaufen vorzugsweise in Längsrichtung des Klebebandes und erhöhen die Zugfestigkeit des Klebebandes erheblich. Problematisch bei der Mehrfachwicklung ist jedoch über die Zugfestigkeit des Klebebandes hinaus die Klebkraft der aufeinanderliegenden Wicklungen. Üblicherweise werden die Klebebänder vor der Applikation auf einer Klebebandrolle zur Verfügung gestellt. Dazu sind die Rückseiten der Klebebänder, also die Seiten, die der Klebmasseschicht an einer Trägerfolie gegenüberliegen, außen mit einer Trennschicht ausgerüstet. Die Trennschicht setzt die Trennkraft zwischen der Trägerfolie und der Klebmasseschicht der nächstfolgenden Klebebandwicklung herab und macht das Klebeband erst abrollbar von der Klebebandrolle. Dadurch wird ein Liner überflüssig, und Kosten werden reduziert. Die Trennschicht kann eine silikonhaltige Schicht, aber auch eine Trennlackierung sein. Die Trennschicht bleibt üblicherweise nach dem Abwickeln des Klebebandes auf der äußeren Seite der Trägerfolie bestehen und setzt natürlich auch beim nachfolgenden Umwickeln des Mediums, wie beispielsweise Hochvoltspeicher, die Trennkräfte zwischen einer Klebebandwicklung und der unmittelbar nachfolgenden äußeren Klebebandwicklung herab. Insbesondere bei sich im Wicklungsquerschnitt ausdehnenden Medien, wie beispielsweise den Hochvoltspeichern, kann dieses dazu führen, dass die Wicklungen des Klebebandwickels durch die sich ausbildenden Dehnungskräfte gelöst werden.

Es ist daher Aufgabe der vorliegenden Erfindung, ein Verfahren zum umwickelnden Verkleben von sich im Querschnitt ausdehnenden Medien zur Verfügung zu stellen, das die oben genannten Nachteile vermeidet.

Es ist auch Aufgabe der vorliegenden Erfindung, eine Einrichtung mit einem auf sich selbst klebenden Klebeband zur Verfügung zu stellen, die die oben genannten Nachteile vermeidet.

Beschrieben wird auch ein Applikator mit dem das erfindungsgemäße Verfahren ausgeführt werden kann.

Die Aufgabe wird in ihrem ersten Aspekt durch ein eingangs genanntes Verfahren mit den Merkmalen des Anspruchs 1 gelöst.

Das Klebeband zur Verwendung in dem erfindungsgemäßen Verfahren weist eine Trägerfolie auf, die sich vorzugsweise in einer gesamten Ausdehnung entlang einer Längsrichtung und Breite eines Klebebandes erstreckt. Auf einer Seite der Trägerfolie ist vorzugsweise vollflächig eine Klebmasseschicht und auf einer der einen Seite gegenüberliegenden Seite der Trägerfolie ist eine vorzugsweise ebenfalls vollflächige Trennmittelschicht vorgesehen.

Das Klebeband wird auf einer Klebebandrolle zur Verfügung gestellt und zur Applikation von der Klebebandrolle abgerollt. Nachdem das Klebeband oder ein Abschnitt des Klebebandes abgerollt ist, wird die Trennmittelschicht außen mit einem Plasma behandelt. Das plasmabehandelte Klebeband wird dann um das sich im Querschnitt ausdehnende Medium in der Weise herumgewickelt, dass zumindest ein Abschnitt des Klebebandes mit der Klebmasseschicht auf einer direkt benachbarten unteren Wicklungslage aufgeklebt wird. Vorzugsweise ist es auch vorgesehen, dass das Klebeband nach der Plasmabehandlung in mehreren, übereinanderklebenden Wicklungslagen um das sich im Wicklungsquerschnitt ausdehnende Medium herumgewickelt wird. Das Klebeband klebt erfindungsgemäß ebenfalls auf sich selbst, zumindest entlang eines Abschnitts einer Wicklungslage oder entlang von mehreren Wicklungslagen.

Als Trägerfolie eignen sich Folien, wie zum Beispiel PA, PU oder PVC, Polyolefinen oder Polyester, vorzugsweise ein Polyester aus PET (Polyethylenterephthalat) Die Folie selbst kann wiederum aus mehreren einzelnen Lagen bestehen, beispielsweise aus zu Folie coextrudierten Lagen.

Bevorzugt werden Polyolefine verwendet, jedoch sind auch Copolymere aus Ethylen und polaren Monomeren wie Styrol, Vinylacetat, Methylmethacrylat, Butylacrylat oder Acrylsäure eingeschlossen. Es kann ein Homopolymer wie HDPE, LDPE, MDPE oder ein Copolymer aus Ethylen oder einem weiteren Olefin wie Propen, Buten, Hexen oder Octen (zum Beispiel LLDPE, VLLDE) sein. Geeignet sind auch Polypropylene (zum Beispiel Polypropylen-Homopolymere, Polypropylen-Random-Copolymere oder Polypropylen-Block-Copolymere).

Erfindungsgemäß hervorragend als Folien einsetzen lassen sich monoaxial und biaxial gereckte Folien. Monoaxial gerecktes Polypropylen beispielsweise zeichnet sich durch seine sehr hohe Reißfestigkeit und geringe Dehnung in Längsrichtung aus.

Besonders bevorzugt sind Folien auf Basis von Polyester, insbesondere solche aus Polyethylenterephthalat.

Die Folie weist vorzugsweise eine Dicke von 12 µm bis 100 µm, weiter vorzugsweise von 28 bis 50 µm, insbesondere 36 µm auf.

Die Folie kann farbig und/oder transparent sein.

Auf einer Seite der Trägerfolie ist eine vorzugsweise vollflächig die Seite der Trägerfolie abdeckende Klebmasseschicht vorgesehen. Es können alle bekannten Klebmassesysteme verwendet werden.

Neben natur- oder synthesekautschukbasierten Klebmassen sind insbesondere Silikonklebmassen sowie Polyacrylatklebmassen, vorzugsweise eine niedermolekulare Acrylatschmelzhaftklebmasse, verwendbar. Letztere sind in der DE 198 07 752 A1 sowie in der DE 100 11 788 A1 näher beschrieben. Auch acrylatbasierende, UV-vernetzende Klebemassen sind geeignet.

Das Auftragsgewicht bewegt sich vorzugsweise im Bereich zwischen 15 bis 200 g/m², weiter vorzugsweise zwischen 30 bis 120 g/m², besonders bevorzugt bei 50 g/m² (das entspricht ungefähr einer Dicke von 15 bis 200 µm, weiter vorzugsweise von 30 bis 120 µm, besonders bevorzugt von 50 µm).

Vorzugsweise ist die Klebmasse eine Haftklebmasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Als Haftklebmassen finden solche auf Basis von Blockcopolymere enthaltenden Polymerblöcken Anwendung. Gebildet werden diese bevorzugt von Vinylaromaten (A-Blöcke) wie zum Beispiel Styrol und solchen durch Polymerisation von 1,3-Dienen (B-Blöcke) wie zum Beispiel Butadien und Isopren oder einem Copolymer aus beiden. Es können auch Mischungen unterschiedlicher Blockcopolymere zum Einsatz kommen. Bevorzugt werden Produkte eingesetzt, die zum Teil oder vollständig hydriert sind.

Die Blockcopolymere können eine lineare A-B-A-Struktur aufweisen. Einsetzbar sind ebenfalls Blockcopolymere von radialer Gestalt sowie sternförmige und lineare Multiblockcopolymere.

Anstelle der Polystyrolblöcke können auch Polymerblöcke auf Basis anderer aromatenhaltiger Homo- und Copolymere (bevorzugt C₈-bis C₁₂-Aromate) mit Glasübergangstemperaturen von > ca. 75 °C genutzt werden wie zum Beispiel α-methylstyrolhaltige Aromatenblöcke. Gleichfalls sind Polymerblöcke auf Basis von (Meth)acrylathomo- und (Meth)acrylatcopolymeren mit Glasübergangstemperaturen von > +75 °C nutzbar. Hierbei können sowohl Blockcopolymere zum Einsatz kommen, welche als Hartblöcke zum einen ausschließlich solche auf Basis von (Meth)acrylatpolymeren nutzen als zum anderen auch solche, die sowohl Polyaromatenblöcke, zum Beispiel Polystyrolblöcke, als auch Poly(meth)acrylatblöcke nutzen.

Die Angaben zur Glasübergangstemperatur für nicht anorganische und nicht überwiegend anorganische Materialien, insbesondere für organische und polymere Materialien, beziehen sich auf den Glasübergangstemperatur-Wert Tg nach DIN 53765:1994-03 (vgl. Abschnitt 2.2.1), sofern im Einzelfall nichts anderes angegeben ist.

Anstelle von Styrol-Butadien-Blockcopolymeren und Styrol-Isopren-Blockcopolymeren und/oder deren Hydrierungsprodukten, mithin Styrol-Ethylen/Butylen-Blockcopolymere und Styrol-Ethylen/Propylen-Blockcopolymere, können erfindungsgemäß ebenfalls Blockcopolymere und deren Hydrierungsprodukte genutzt werden, welche weitere polydienhaltige Elastomerblöcke nutzen wie zum Beispiel Copolymere mehrerer unterschiedlicher 1,3-Diene. Erfindungsgemäß nutzbar sind des Weiteren funktionalisierte Blockcopolymere wie zum Beispiel maleinsäureanhydridmodifizierte oder silanmodifizierte Styrolblockcopolym ere.

Typische Einsatzkonzentrationen für das Blockcopolymer liegen in einer Konzentration im Bereich zwischen 30 Gew.-% und 70 Gew.-%, insbesondere im Bereich zwischen 35 Gew.-% und 55 Gew.-%.

Als weitere Polymere können solche auf Basis reiner Kohlenwasserstoffe wie zum Beispiel ungesättigte Polydiene wie natürliches oder synthetisch erzeugtes Polyisopren oder Polybutadien, chemisch im Wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk sowie chemisch funktionalisierte Kohlenwasserstoffe wie zum Beispiel halogenhaltige, acrylathaltige oder vinyletherhaltige Polyolefine vorhanden sein, welche die vinylaromatenhaltigen Blockcopolymere bis zur Hälfte ersetzen können.

Als Klebrigmacher dienen Klebharze.

Geeignete Klebharze sind unter anderem vorzugsweise partiell oder vollständig hydrierte Harze auf Basis von Kolophonium oder Kolophoniumderivaten. Es können auch zumindest zum Teil hydrierte Kohlenwasserstoffharze, zum Beispiel hydrierte Kohlenwasserstoffharze, erhalten durch teilweise oder vollständige Hydrierung von aromatenhaltigen Kohlenwasserstoffharzen (zum Beispiel Arkon P und Arkon M Serien der Firma Arakawa oder Regalite-Serie von Eastman), Kohlenwasserstoffharze auf Basis von hydrierten Dicyclopentadien-Polymeren (zum Beispiel Escorez 5300er-Serie von Exxon), Kohlenwasserstoffharze auf Basis von hydrierten C5/C9-Harzen (Escorez 5600er-Serie von Exxon) oder Kohlenwasserstoffharze auf Basis von hydrierten C5-Harzen (Eastotac der Firma Eastman) beziehungsweise deren Gemische eingesetzt werden.

Auch hydrierte Polyterpenharze auf Basis von Polyterpenen sind verwendbar. Vorgenannte Klebharze können sowohl allein als auch im Gemisch eingesetzt werden.

Als weitere Additive können typischerweise Lichtschutzmittel wie zum Beispiel UV-Absorber, sterisch gehinderte Amine, Antiozonantien, Metalldesaktivatoren, Verarbeitungshilfsmittel, endblockverstärkende Harze eingesetzt werden.

Plastifizierungsmittel wie zum Beispiel Flüssigharze, Weichmacheröle oder niedermolekulare flüssige Polymere wie zum Beispiel niedermolekulare Polyisobutylene mit Molmassen < 1500 g/mol (Zahlenmittel) oder flüssige EPDM-Typen werden typischerweise eingesetzt.

Die Klebmasse kann in Längsrichtung des Klebebands in Form eines Streifens aufgebracht sein, der eine geringere Breite aufweist als der Träger des Klebebands.

Der beschichtete Streifen kann eine Breite von 10 bis 80 % der Breite des Trägermaterials haben. Besonders vorzugsweise erfolgt in einem solchen Fall der Einsatz von Streifen mit einer Beschichtung von 20 bis 50 % der Breite des Trägermaterials.

Je nach Verwendungsfall können auch mehrere parallele Streifen des Klebers auf dem Trägermaterial beschichtet sein.

Die Lage des Streifens auf dem Träger ist frei wählbar, wobei eine Anordnung direkt an einer der Kanten des Trägers bevorzugt wird.

Schließlich kann das Klebeband ein Abdeckmaterial aufweisen, mit dem bis zum Gebrauch die eine Klebmasseschicht eingedeckt ist. Als Abdeckmaterialien eignen sich auch alle oben ausführlich aufgeführten Materialien.

Bevorzugt wird aber ein nicht-fusselndes Material eingesetzt wie eine Kunststofffolie oder ein gut verleimtes, langfaseriges Papier.

Die Herstellung und Verarbeitung der Klebemassen kann aus Lösung, Dispersion sowie aus der Schmelze erfolgen. Bevorzugte Herstellungs- und Verarbeitungsverfahren erfolgen aus Lösung sowie aus der Schmelze. Besonders bevorzugt ist die Fertigung der Klebmasse aus der Schmelze, wobei insbesondere Batchverfahren oder kontinuierliche Verfahren eingesetzt werden können. Besonders vorteilhaft ist die kontinuierliche Fertigung der Haftklebmassen mit Hilfe eines Extruders.

Bei Verarbeitung aus der Schmelze können dies Auftragsverfahren über eine Düse oder einen Kalander sein.

Bei Verfahren aus der Lösung sind Beschichtungen mit Rakeln, Messern oder Düsen bekannt, um nur einige wenige zu nennen.

Auf der gegenüberliegenden Seite der Trägerfolie, also der Seite, die der Klebmasseschicht gegenüberliegt, ist die Trägerfolie mit einer Trennmittelschicht versehen. Die Trennmittelschicht deckt die gegenüberliegende Seite der Trägerfolie ebenfalls vorzugsweise vollflächig ab.

Trennmittel, auch Release genannt, können auf verschiedene Weise ausgebildet sein. Geeignete Trennmittel umfassen tensidische Releasesysteme auf Basis langkettiger Alkylgruppen wie Stearylsulfosuccinate oder Stearylsulfosuccinamate, aber auch Polymere, die ausgewählt sein können aus der Gruppe bestehend aus Polyvinylstearylcarbamaten, Polyethyleniminstearylcarbamiden, Chrom-Komplexen von C₁₄-C₂₈-Fettsäuren und Stearyl-Copolymeren, wie zum Beispiel in DE 28 45 541 A beschrieben. Ebenfalls geeignet sind Trennmittel auf Basis von Acrylpolymeren mit perfluorierten Alkylgruppen, Silikone oder Fluorsilikonverbindungen, zum Beispiel auf Basis von Poly(dimethyl-)siloxanen. Besonders bevorzugt umfasst die Releaseschicht ein Polymer auf Silikonbasis. Besonders bevorzugte Beispiele solcher trennwirksamen Polymere auf Silikonbasis umfassen polyurethan- und/oder polyharnstoffmodifizierte Silikone, bevorzugt Organopolysiloxan/Polyharnstoff/Polyurethan-Blockcopolymere, besonders bevorzugt solche wie in Beispiel 19 der EP 1 336 683 B1 beschrieben, ganz besonders bevorzugt anionisch stabilisierte polyurethan- und harnstoffmodifizierte Silikone mit einem Silikon-Gewichtsanteil von 70 % und einer Säurezahl von 30 mg KOH/g. Der Einsatz polyurethan- und/oder harnstoffmodifizierter Silikone bedingt den Effekt, dass die erfindungsgemäßen Produkte bei optimierter Alterungsbeständigkeit und universeller Beschriftbarkeit ein optimiertes Trennverhalten aufweisen. In einer bevorzugten Ausführungsform der Erfindung umfasst die Releaseschicht 10 bis 20 Gew.-%, besonders bevorzugt 13 bis 18 Gew.-% des trennwirksamen Bestandteils.

Problematisch an den bekannten Klebebändern ist die Tatsache, dass die Trennmittelschicht zum einen die Trennkräfte zwischen Klebmasseschicht und Trägerfolie vorteilhaft herabsetzen soll, damit ein Aufwickeln des Klebebandes auf sich selbst zur Lagerung möglich ist und auch ein Abrollen wieder ermöglicht. Das abgewickelte Klebeband weist immer noch eine Trennmittelschicht auf, so dass beim späteren erneuten Wickeln des Klebebandes um das sich im Wicklungsquerschnitt veränderliche Medium herum ebenfalls, nun aber nachteiligerweise, die Trennkräfte zwischen Klebmasseschicht und darunterliegender Trägerfolie verringern und die Festigkeit des Wickels verringern.

Überraschenderweise hat sich aber gezeigt, dass durch eine Plasmabehandlung des abgewickelten Klebebandes nach dem Abwickeln die Trennkräfte in einem unerwartet hohen Maße erhöht werden können, wenn die Trennmittelschicht außen, also auf der der Trägerfolie gegenüberliegenden Seite mit einem Plasma behandelt wird.

Eine Coronabehandlung, die zu den Plasmabehandlungen zählt, ist als eine durch hohe Wechselspannung zwischen zwei Elektroden erzeugte Oberflächenbehandlung mit filamentären Entladungen definiert, wobei die diskreten Entladungskanäle auf die zu behandelnde Oberfläche treffen, siehe dazu auch Wagner et al., Vacuum, 71 (2003), Seiten 417 bis 436. Als Prozessgas kann Umgebungsluft, Kohlendioxid oder Stickstoff, Edelgas oder Sauerstoff verwendet werden. Dem Prozessgas können auch weitere gasförmige Stoffe aus der Gruppe Siloxan, Acrylsäuren oder Lösungsmittel oder Wasserstoff, Alkane, Alkene, Alkine, Silan, siliziumorganische Monomere, Acrylatmonomere, Wasser, Alkohole, Peroxide und organische Säuren beigemischt werden.

Fast immer wird das Substrat im Entladungsraum zwischen einer Elektrode und einer Gegenelektrode platziert oder hindurchgeführt, was als "direkte" physikalische Behandlung definiert ist. Bahnförmige Substrate werden dabei typischerweise zwischen einer Elektrode und einer geerdeten Walze hindurchgeführt.

Insbesondere wird in industriellen Anwendungen meist unter dem Begriff "Corona" eine "dielektrische Barrierenentladung" (engl. dielectric barrier discharge, DBD) verstanden. Dabei besteht mindestens eine der Elektroden aus einem Dielektrikum, also einem Isolator, oder ist mit einem solchen beschichtet oder überzogen. Die zweite Elektrode weist kleine Radien oder Spitzen auf um den Coronaeffekt, den Effekt großer Gradienten des elektrischen Feldes, zu erzeugen. Das Substrat kann hierbei auch als Dielektrikum fungieren.

Die Behandlungsintensität einer Coronabehandlung wird als "Dosis" in [Wmin/m²] angegeben, mit der Dosis D=P/b*v, mit P=elektrischer Leistung [W], b=Elektrodenbreite [m], und v=Bahngeschwindigkeit [m/min].

Fast immer wird das Substrat im Entladungsraum zwischen einer Elektrode und einer Gegenelektrode platziert oder hindurchgeführt, was als "direkte" physikalische Behandlung definiert ist. Bahnförmige Substrate werden dabei typischerweise zwischen einer Elektrode und einer geerdeten Walze hindurchgeführt. Manchmal wird noch der Begriff einer "ausgeblasenen Corona" beziehungsweise "einseitigen Corona" verwendet.

Aus der FR 2 443 753 ist eine Vorrichtung zur Oberflächenbehandlung mittels einer Coronaentladung bekannt. Dabei sind die beiden Elektroden auf der gleichen Seite der zu behandelnden Oberfläche des Objektes angeordnet, wobei die ersten Elektroden aus einer Vielzahl von Punkten gebildet sind, entlang derer eine gekrümmte Anordnung einer zweiten Elektrode vorgesehen ist. Zwischen den beiden Elektroden wird eine Wechselspannung mit einigen kV mit einer Frequenz von 10 kHz angelegt. Die Coronaentladung entlang der Feldlinien beeinflusst dabei die vorbeigeführte Oberfläche und führt zu einer Polarisierung der Oberfläche, wodurch die Haftungseigenschaften einer Haftklebmasse auf der durch den Coronaeffekt behandelten Oberfläche verbessert werden.

Eine gleichmäßigere intensive Behandlung von Materialien verschiedener Art, Form und Dicke zu ermöglichen, besteht darin, Entladungsfilamente wie sie bei Coronaentladungen auftreten zu vermeiden, indem gemäß der EP 0 497 996 B1 eine Doppelstiftelektrode gewählt wird, wobei für jede Stiftelektrode ein eigener Kanal zur Druckbeaufschlagung vorhanden ist. Zwischen den beiden Spitzen der Elektroden entsteht eine Coronaentladung, die den durch die Kanäle strömenden Gasstrom ionisiert und in ein Plasma umwandelt. Dieses Plasma gelangt dann als Remote- oder Afterglow-Plasma durch den Gasstrom an die zu behandelnde Oberfläche und führt dort insbesondere eine Oberflächenoxidation durch, welche die Benetzbarkeit der Oberfläche verbessert. Die Art der physikalischen Behandlung wird (hier) als indirekt bezeichnet, weil die Behandlung nicht am Erzeugungsort der elektrischen Entladung vorgenommen wird. Die Behandlung der Oberfläche findet bei oder nahe bei Atmosphärendruck statt, wobei jedoch der Druck im elektrischen Entladungsraum oder Gaskanal erhöht sein kann. Unter dem Plasma wird hier ein Atmosphärendruckplasma verstanden, das ein elektrisch aktiviertes homogenes reaktives Gas ist, das sich nicht im thermischen Equilibrium befindet, mit einem Druck nahe dem Umgebungsdruck im Wirkbereich. Durch die elektrischen Entladungen und durch lonisierungsprozesse im elektrischen Feld wird das Gas aktiviert, und es werden hochangeregte Zustände in den Gasbestandteilen erzeugt. Das verwendete Gas und die Gasmischung werden als Prozessgas bezeichnet. Als Prozessgas werden vorzugsweise Luft, Kohlendioxid, Edelgas, Stickstoff oder Sauerstoff oder Mischungen davon verwendet. Grundsätzlich können dem Prozessgas auch gasförmige Stoffe wie Siloxan, Acrylsäuren oder Lösungsmittel oder auch weitere gasförmige Stoffe wie zum Beispiel Siloxan, Acrylsäuren oder Wasserstoff, Alkane, Alkene, Alkine, Silane, siliziumorganische Monomere, Acrylatmonomere, Wasser, Alkohole, Peroxide und organische Säuren oder andere Bestandteile beigemischt werden. Bestandteile des Atmosphärendruckplasmas können hochangeregte atomare Zustände, hochangeregte molekulare Zustände, Ionen, Elektronen, unveränderte Bestandteile des Prozessgases sein. Das Atmosphärendruckplasma wird nicht in einem Vakuum erzeugt, sondern üblicherweise in Luftumgebung. Das bedeutet, dass das ausströmende Plasma, wenn das Prozessgas nicht selbst schon Luft ist, zumindest Bestandteile der umgebenden Luft enthält.

Bei einer Coronaentladung nach obiger Definition bilden sich durch die angelegte hohe Spannung filamentäre Entladungskanäle mit beschleunigten Elektronen und Ionen. Insbesondere die leichten Elektronen treffen mit hoher Geschwindigkeit auf die Oberfläche mit Energien, die ausreichen, um die meisten Molekülbindungen aufzubrechen. Die Reaktivität der außerdem entstehenden reaktiven Gasbestandteile ist meist ein untergeordneter Effekt. Die aufgebrochenen Bindungsstellen reagieren dann mit Bestandteilen der Luft oder des Prozessgases weiter. Ein entscheidender Effekt ist die Bildung kurzkettiger Abbauprodukte durch Elektronenbeschuss. Bei Behandlungen höherer Intensität tritt auch ein signifikanter Materialabtrag ein.

Durch die Reaktion eines Plasmas mit der Substratoberfläche werden verstärkt die Plasmabestandteile direkt "eingebaut". Alternativ können auf der Oberfläche ein angeregter Zustand oder eine offene Bindungsstelle und Radikale erzeugt werden, die dann sekundär weiterreagieren, zum Beispiel mit Luftsauerstoff aus der Umgebungsluft. Bei manchen Gasen wie Edelgasen ist keine chemische Bindung der Prozessgasatome oder Moleküle an das Substrat zu erwarten. Hier findet die Aktivierung des Substrats ausschließlich über Sekundärreaktionen statt.

Der wesentliche Unterschied ist also, dass bei der Plasmabehandlung keine direkte Einwirkung diskreter Entladungskanäle auf die Oberfläche stattfindet. Die Wirkung findet also homogen und schonend, vor allem über reaktive Gasbestandteile statt. Bei einer indirekten Plasmabehandlung sind freie Elektronen möglicherweise vorhanden, aber nicht beschleunigt, da die Behandlung außerhalb des erzeugenden elektrischen Feldes stattfindet.

Die Plasmabehandlung ist aufgrund der Spezieszusammensetzung schonender und homogener als eine Coronabehandlung, da keine diskreten Entladungskanäle auf die Oberfläche treffen. Es entstehen weniger kurzkettige Abbauprodukte des behandelten Materials, die eine Schicht mit negativem Einfluss auf der Oberfläche bilden können. Deswegen können oft bessere Benetzbarkeiten nach Plasmabehandlung gegenüber Coronabehandlung erzielt werden bei längerer Beständigkeit des Effekts. Die Plasmabehandlung einer Trennmittelschicht um die Anhaftung eines mit Haftklebstoff versehenen Klebebandes zu verbessern wird in der US 5,106,383 A beschrieben.

Im handwerklichen und industriellen Einsatz können die Plasma erzeugenden Geräte in einen Applikator zur Aufbringung des Klebebandes auf das Medium oder Substrat integriert sein. Diese Applikatoren können automatisiert, händisch oder händisch technisch unterstützt geführt werden.

Der Applikator umfasst eine Klebebandrolle und eine Abwickeleinrichtung für ein Klebeband von der Klebebandrolle, wobei das von der Klebebandrolle abgewickelte Klebeband auf einer Seite einer Trägerfolie mit einer Klebmasseschicht und auf einer gegenüberliegenden Seite mit einer Trennmittelschicht versehen ist, und er umfasst eine Plasmadüse, die auf die Trennmittelschicht des abgewickelten Klebebandes gerichtet ist. Vorzugsweise sind die Plasmadüse und die Abwickeleinrichtung, insbesondere ein Aufnahmezapfen für die Klebebandrolle und/oder ein Bereich, in dem das abgewickelte Klebeband an der Plasmadüse vorbeigeführt wird, in ihrer relativen Anordnung zueinander fixiert und konstant, so dass eine gleichbleibende Plasmabehandlung der Trennmittelschicht während des Abwickelns erfolgt.

Günstigerweise weist der Applikator eine Schneidvorrichtung für das Klebeband auf. Die Schneidvorrichtung gestattet es, das abgewickelte und aufgeklebte Klebeband abzuschneiden.

Besonders bevorzugt umfasst der Applikator eine Absaugvorrichtung für bei der Plasmabehandlung anfallende Reaktionsprodukte wie zum Beispiel Ozon oder Stickoxide.

Der Applikator kann auch eine Andruckwalze zum Andrücken des Klebebandes auf das Substrat enthalten.

Weiterhin können Auffangvorrichtungen für eventuell vorhandene Liner vorgesehen sein.

Das Klebeband wird so durch den Applikator geführt, dass eine Plasmabehandlung des Klebebandes unter gleichbleibenden Behandlungsparametern, wie zum Beispiel Abstand zur Plasmaquelle und Behandlungsgeschwindigkeit, möglich ist.

In einer bevorzugten Ausführungsform der Erfindung weist das Klebeband wenigstens ein in Längsrichtung des Klebebandes verlaufendes Filament auf, das die Zugfestigkeit erhöht. Bei einem Filament kann es sich insbesondere um Glasfilamente oder PET-Filamente handeln. Die Filamente können in die Trägerfolie und oder auch in die Klebmasseschicht integriert sein. Üblicherweise bestehen die Filamente aus einem Bündel an Einzelfilamenten, wobei das Bündel durch Schlichte, also ein Bindemittel, verklebte Einzelfilamente gebildet wird.

Die Filamente können in Längsrichtung nebeneinander, voneinander beabstandet angeordnet sein oder auch als Gelege oder Gewebe in die Trägerfolie oder die Klebmasseschicht oder beides integriert sein.

Das Filamentgelege oder -gewebe weist eine Zugfestigkeit in Längsrichtung von vorzugsweise mindestens 100 N/cm, weiter vorzugsweise 200 N/cm, besonders vorzugsweise 500 N/cm auf.

Vorzugsweise weisen die zur Bildung des Geleges oder des Gewebes verwendeten Garne eine Stärke von 80 bis 2200 dtex, vorzugsweise 280 bis 1100 dtex auf.

Im Sinne dieser Erfindung wird unter einem Filament ein Bündel paralleler gerader Einzelfasern/Einzelfilamente verstanden, das in der Literatur auch oft als Multifilament bezeichnet wird. Gegebenenfalls kann dieses Faserbündel durch Verdrehen in sich verfestigt werden, dann spricht man von gesponnenen oder gezwirnten Filamenten. Alternativ kann das Faserbündel durch Verwirbeln mit Druckluft oder Wasserstrahl in sich verfestigt werden. Im Weiteren wird für alle diese Ausführungsformen verallgemeinernd nur noch der Begriff Filament verwendet.

Das Filament kann texturiert oder glatt und punktverfestigt oder unverfestigt vorliegen.

Das Gelege/Gewebe kann nachträglich gefärbt sein oder aus spinngefärbten Garnen bestehen.

Weiter bevorzugt bestehen die Filamente aus Polyester, Polypropylen, Polyethylen oder Polyamid, bevorzugt Polyester (Diolen).

Die Erfindung wird in ihrem zweiten Aspekt durch eine Einrichtung mit den Merkmalen des Anspruchs 8 gelöst.

Der Begriff der Einrichtung ist hier allgemein zu verstehen. Er umfasst ein Medium, das einen in seiner Größe veränderlichen Wicklungsquerschnitt aufweist, wie beispielsweise Transformatoren, Verpackungen, Stahlbündel, Batterien und Hochvoltspeicher. Vorzugsweise sind die Medien in einer Wicklungsquerschnittsgröße durch vorzugsweise Temperatureinflüsse veränderlich. Um das Medium herum ist entlang des Wicklungsquerschnitts ein auf sich selbst gewickeltes Klebeband vorgesehen, das das Medium umläuft und auf ihm umlaufend aufliegt und auf ihm aufgeklebt ist

Die Einrichtung weist ein auf sich selbst gewickeltes Klebeband mit einer Trägerfolie auf, auf deren einer Seite eine Klebmasseschicht und auf deren anderer Seite eine außen plasmabehandelte Trennmittelschicht aufgebracht ist. Das Klebeband ist vorgesehen insbesondere zum Umwickeln von sich in einem Wicklungsquerschnitt ausdehnenden Medien, wie beispielweise Hochvoltspeichern. Die Einrichtung wird insbesondere hinsichtlich des Klebebandes vorzugsweise durch eines der oben genannten Verfahren hergestellt.

Die Erfindung wird anhand eines Ausführungsbeispiels in einer Figur beschrieben.

### Dabei zeigen

- Fig. 1: eine schematische Darstellung eines statischen Schertests,

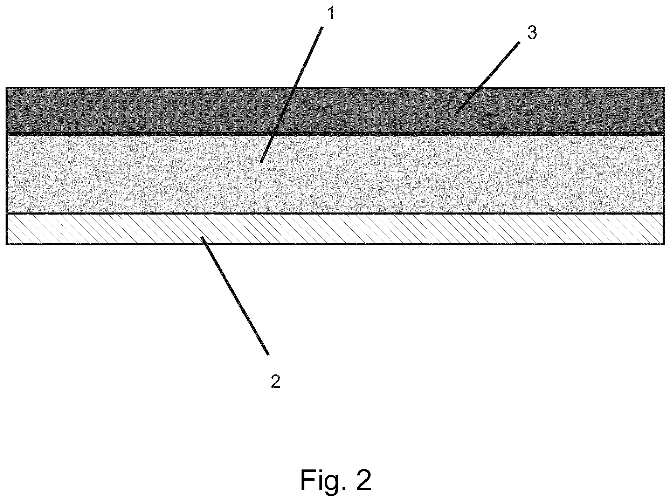

- Fig. 2: einen beispielhaften Aufbau eines erfindungsgemäßen Klebebands.

Die Erfindung betrifft ein Verfahren zur mehrfachen Umwicklung von sich im Wicklungsquerschnitt ausdehnenden Medien. Ein Beispiel einer solchen Anwendung ist die Herstellung von Hochvoltspeichern, bei der das Klebeband mehrlagig auf sich selbst verklebt wird. Durch die Vorspannung bei der Umwicklung und durch Ausdehnungsprozesse während des Lade- und Entladevorganges der Batterien wird eine Kraft auf den Klebebandwickel ausgeübt. Um den bei der Ausdehnung der Batterie entstehenden Zugkräften auf das Klebeband zu widerstehen, ist das Klebeband mit einem oder mehreren in Längsrichtung verlaufenden Filamenten verstärkt.

Das erfindungsgemäße Klebeband weist eine Trägerfolie 1 auf und auf der einen Seite der Trägerfolie 1 eine Klebmasseschicht 2 und auf der gegenüberliegenden Seite eine Trennmittelschicht 3. Als Haftklebmasse wird eine Acrylatklebemasse verwendet. Als Trennmittel wird hier Silikon verwendet. Das Silikon hat zum einen die Eigenschaft, dass es die Trennkräfte zwischen der Klebmasseschicht 2 und der Trägerfolie 1 bei einem auf einer Rolle aufgewickelten Klebeband zwischen aufeinanderfolgenden Lagen herabsetzt, so dass das Klebeband zwischen der Klebmasseschicht 2 der oberen Lage und der Trägerfolie 1 der unmittelbar benachbarten unteren Lage leicht abgezogen werden kann und appliziert werden kann. Das Trennmittel verbleibt als Trennmittelschicht 3 auf der Trägerfolie 1, so dass bei einem erneuten Applizieren des Klebebandes beim Umwickeln der Hochvoltspeicher, die Trennkräfte zwischen aufeinanderfolgenden Klebebandlagen in diesem Fall unerwünschterweise herabgesetzt werden.

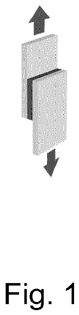

Eine Möglichkeit, die Klebkraft der Klebmasse, die auf der einen Seite der Trägerfolie aufgebracht ist, auf der anderen Seite zu prüfen, ist die Ermittlung der Scherbeständigkeit bei Verklebung auf der anderen Seite. Bei der verwendeten Methode zur Bestimmung der Scherbeständigkeit handelt es sich um einen dynamischen Schertest, der in Fig. 1 dargestellt ist. Die Prüfung wird wie folgt durchgeführt. Auf der Rückseite eines 40 x 25 mm großen Klebebandstreifens wird ein Klebebandstreifen von 40 x 25 mm auf einer Fläche von 25 x 25 mm verklebt; die Verklebungsfläche wird mit 100 N/cm² für eine Minute angedrückt. Der Klebebandverbund wird mit den überstehenden Klebebandstreifen mit einer Zugprüfmaschine befestigt; die Probe wird mit einer Geschwindigkeit von 50 mm pro Minute auseinandergezogen, gemessen wird die Kraft bezogen auf die Verklebungsfläche (N/cm²) bei der der Klebebandstreifen abgeschert wurde. Die Zugkräfte sind durch Pfeile dargestellt. Aus Vereinfachungsgründen ist die Klebemasse des oberen Klebebandstreifens überhaupt nicht dargestellt. Weiterhin ist bei dem zweiten Streifen die Klebemasse nur in der Verklebungsfläche gezeigt.

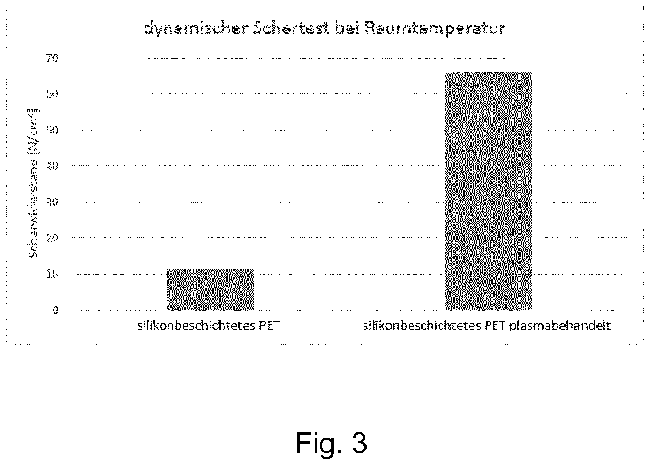

Durch eine physikalische Oberflächenbehandlung in Form einer Plasmabehandlung direkt vor der Applizierung des Klebebandes auf der Klebebandrückseite wird die Oberfläche für die Verklebung optimiert. Die Trägerfolie ist hier eine PET Folie. Die nachfolgende Graphik zeigt, dass die Scherbeständigkeit trotz der Beschichtung der Klebebandrückseite mit Silikon durch die Plasmabehandlung deutlich und unerwartet hoch, nämlich nahezu um den Faktor 6, ansteigt (siehe Figur 3).

Gegenüber den Klebebändern ohne Plasmabehandlung der Rückseite ergibt sich so eine deutlich sicherere Fixierung bei einer Mehrlagenverklebung in Form eines Klebebandwickels. Dennoch ist das Klebeband von der Klebebandrolle, auf der es zur Verfügung gestellt wird, nach wie vor in herkömmlicher Weise gut abrollbar.

## Patentansprüche

1. Verfahren zum umwickelnden Verkleben von einem sich potentiell in einem Wicklungsquerschnitt ausdehnenden Medium mit einem Klebband, indem:
ein Klebeband von einer Klebebandrolle abgewickelt wird,
das abgewickelte Klebeband an einer Seite einer Trägerfolie (1) mit einer Klebmasseschicht (2) und auf einer gegenüberliegenden Seite mit einer Trennmittelschicht (3) versehen ist,
die Trennmittelschicht (3) mit einem Plasma behandelt wird,
das plasmabehandelte Klebeband um das sich potentiell im Wicklungsquerschnitt ausdehnende Medium herumgewickelt wird, so dass zumindest ein Abschnitt des Klebebandes mit der Klebmasseschicht (2) auf einer unteren Wicklungslage aufgeklebt wird.

2. Verfahren nach Anspruch 1,
**dadurch gekennzeichnet, dass** das Klebeband in mehreren übereinander klebenden Wicklungslagen um das Medium herumgewickelt wird.

3. Verfahren nach Anspruch 1 oder 2,
**dadurch gekennzeichnet, dass** das Klebeband mit wenigstens einem Filament versehen wird, das die Zugfestigkeit erhöht.

4. Verfahren nach einem der Ansprüche 1, 2 oder 3,
**dadurch gekennzeichnet, dass** ein Trennmittel der Trennmittelschicht (3) aus der Gruppe ausgewählt wird: tensidische Releasesysteme auf Basis langkettiger Alkylgruppen wie Stearylsulfosuccinate oder Stearylsulfosuccinamate; Polymere, die aus der Gruppe bestehend aus Polyvinylstearylcarbamaten, Polyethyleniminstearylcarbamiden, Chrom-Komplexen von C14 - C28 Fettsäuren und Stearyl-Copolymeren sein können oder auf Basis von Acrylpolymeren mit perfluorierten Alkylgruppen; Silikone oder Fluorsilikonverbindungen, insbesondere auf Basis von Poly(dimethyl-)siloxanen.

5. Verfahren nach einem der vorstehenden Ansprüche,
**dadurch gekennzeichnet, dass** eine Klebmasse der Klebmasseschicht (2) aus der Gruppe auf natur- oder synthesekautschukbasierten Klebmassen, Silikonklebmassen sowie insbesondere Polyacrylatklebmassen gewählt wird.

6. Verfahren nach einem der vorstehenden Ansprüche,
**dadurch gekennzeichnet, dass** Luft, Kohlendioxid, Edelgas, Stickstoff oder Sauerstoff oder Mischungen davon als Prozessgas zur Plasmabehandlung verwendet werden.

7. Verfahren nach Anspruch 6,
**dadurch gekennzeichnet, dass** dem Prozessgas weitere gasförmige Stoffe aus der Gruppe Siloxan, Acrylsäuren oder Lösungsmittel oder Wasserstoff, Alkane, Alkene, Alkine, Silan, siliziumorganische Monomere, Acrylatmonomere, Wasser, Alkohole, Peroxide und organische Säuren beigemischt werden.

8. Einrichtung mit
einem Medium mit einem in einer Größe veränderlichen Wicklungsquerschnitt und einem um das Medium herum entlang des Wicklungsquerschnitts auf sich selbst gewickelten Klebeband mit
einer Trägerfolie (1), auf deren einer Seite eine Klebmasseschicht (2) und auf deren anderer Seite eine plasmabehandelte Trennmittelschicht (3) aufgebracht ist.

9. Einrichtung nach Anspruch 8,
**dadurch gekennzeichnet, dass** das Klebeband in mehreren Wicklungslagen übereinander geklebt ist.

10. Einrichtung nach Anspruch 8 oder 9,
**dadurch gekennzeichnet, dass** das Klebeband wenigstens ein Filament aufweist, das die Zugfestigkeit erhöht.

11. Einrichtung nach einem der Ansprüche 8, 9 oder 10,
**dadurch gekennzeichnet, dass** eine Mehrzahl an Filamenten im Klebeband vorgesehen ist.

12. Einrichtung nach einem der Ansprüche 8 bis 11,
**dadurch gekennzeichnet, dass** ein Trennmittel der Trennmittelschicht (3) aus der Gruppe stammt: tensidische Releasesysteme auf Basis langkettiger Alkylgruppen wie Stearylsulfosuccinate oder Stearylsulfosuccinamate; Polymere, die aus der Gruppe bestehend aus Polyvinylstearylcarbamaten, Polyethyleniminstearylcarbamiden, Chrom-komplexen von C14 - C28 Fettsäuren und Stearyl-Copolymeren sein können oder auf Basis von Acrylpolymeren mit perfluorierten Alkylgruppen; Silikone oder Fluorsilikonverbindungen, insbesondere auf Basis von Poly(dimethyl-)siloxanen.

13. Einrichtung nach einem der Ansprüche 8 bis 12,
**dadurch gekennzeichnet, dass** eine Klebmasse der Klebmasseschicht (2) aus der Gruppe natur- oder synthesekautschukbasierten Klebmassen, Silikonklebmassen sowie insbesondere Polyacrylatklebmassen stammt.

## Claims

1. Method for bonding by wrapping a medium which is capable of expanding transversely to a winding with an adhesive tape, in which:
an adhesive tape is unrolled from an adhesive tape roll,
the unrolled adhesive tape is provided on one side of a carrier film (1)
with an adhesive cement layer (2) and on an opposite side with a separating agent layer (3),
the separating agent layer (3) is subjected to a plasma treatment,
the plasma-treated adhesive tape is wound around the medium which is capable of expanding transversely to a winding, so that at least a portion of the adhesive tape is bonded to the adhesive cement layer (2) on a lower winding ply.

2. Method according to Claim 1,
**characterized in that** the adhesive tape is wound around the medium in several winding plies which are bonded one on top of the other.

3. Method according to Claim 1 or 2,
**characterized in that** the adhesive tape is furnished with at least one filament, which increases its tensile strength.

4. Method according to any one of Claims 1, 2 or 3, **characterized in that** a separating agent in the separating agent layer (3) is selected from the group of: surfactant release systems based on long-chain alkyl groups such as stearyl sulfosuccinates or stearyl sulfosuccinamates; polymers which may be from the group consisting of polyvinylstearyl carbamates, polyethylene imine stearyl carbamides, chromium complexes of C14 - C28 fatty acids and stearyl copolymers or based on acrylic polymers with perfluorinated alkyl groups; silicones or fluorosilicone compounds, particularly based on poly(dimethyl-)siloxanes.

5. Method according to any one of the preceding claims, **characterized in that** an adhesive cement of the adhesive cement layer (2) is selected from the group of adhesive cements based on natural or synthetic rubber, silicone adhesive cements and particularly polyacrylate adhesive cements.

6. Method according to any one of the preceding claims, **characterized in that** air, carbon dioxide, inert gas, nitrogen or oxygen or mixtures thereof is/are used as the process gas for the plasma treatment.

7. Method according to Claim 6,
**characterized in that** additional gas-phase substances from the group of siloxane, acrylic acids or solvents or hydrogen, alkanes, alkenes, alkynes, silane, silicon-organic monomers, acrylate monomers, water, alcohols, peroxides and organic acids are added to the process gas.

8. Device with
a medium whose size is variable transversely to the winding and
an adhesive tape that is wound onto itself around the medium transversely to the winding with a carrier film (1), on one side of which an adhesive cement layer (2) is applied, and on the other side of which a plasma-treated separating agent layer (3) is applied.

9. Device according to Claim 8,
**characterized in that** the adhesive tape is bonded in several winding plies one on top of the other.

10. Device according to Claim 8 or 9,
**characterized in that** the adhesive tape includes at least one filament which increases the tensile strength thereof.

11. Device according to any one of Claims 8, 9 or 10, **characterized in that** a plurality of filaments is provided in the adhesive tape.

12. Device according to any one of Claims 8 to 11, **characterized in that** a separating agent in the separating agent layer (3) originates from the group of: surfactant release systems based on long-chain alkyl groups such as stearyl sulfosuccinates or stearyl sulfosuccinamates; polymers which may be from the group consisting of polyvinylstearyl carbamates, polyethylene imine stearyl carbamides, chromium complexes of C14 - C28 fatty acids and stearyl copolymers or based on acrylic polymers with perfluorinated alkyl groups; silicones or fluorosilicone compounds, particularly based on poly(dimethyl-)siloxanes.

13. Device according to any one of Claims 8 to 12, **characterized in that** an adhesive cement in the adhesive cement layer (2) originates from the group of adhesive cements based on natural or synthetic rubber, silicone adhesive cements and particularly polyacrylate adhesive cements.

## Revendications

1. Procédé de collage en enroulement d'un milieu s'élargissant potentiellement dans une coupe transversale d'enroulement avec une bande adhésive, dans lequel :
une bande adhésive est déroulée d'un rouleau de bande adhésive,
la bande adhésive déroulée est munie sur un côté d'un film support (1) d'une couche de masse adhésive (2) et
sur un côté opposé d'une couche d'agent antiadhésif (3),
la couche d'agent antiadhésif (3) est traitée avec un plasma,
la bande adhésive traitée par plasma est enroulée autour du milieu s'élargissant potentiellement dans la coupe transversale d'enroulement, de telle sorte qu'au moins une section de la bande adhésive soit collée avec la couche de masse adhésive (2) sur une couche d'enroulement inférieure.

2. Procédé selon la revendication 1,
**caractérisé en ce que** la bande adhésive est enroulée en plusieurs couches d'enroulement adhérant les unes sur les autres autour du milieu.

3. Procédé selon la revendication 1 ou 2,
**caractérisé en ce que** la bande adhésive est munie d'au moins un filament, qui augmente la résistance à la traction.

4. Procédé selon l'une quelconque des revendications 1, 2 ou 3, **caractérisé en ce qu'**un agent antiadhésif de la couche d'agent antiadhésif (3) est choisi dans le groupe comprenant : les systèmes de séparation tensioactifs à base de groupes alkyle à chaîne longue tels que les sulfosuccinates de stéaryle ou les sulfosuccinamates de stéaryle ; les polymères, qui peuvent être du groupe constitué par les carbamates de polyvinylstéaryle, les polyéthylène-imine-stéarylcarbamides, les complexes de chrome d'acides gras en C14 à C28 et les copolymères de stéaryle, ou à base de polymères acryliques dotés de groupes alkyle perfluorés ; les silicones ou les composés de fluorosilicone, notamment à base de poly(diméthyl-)siloxanes.

5. Procédé selon l'une quelconque des revendications précédentes,
**caractérisé en ce qu'**une masse adhésive de la couche de masse adhésive (2) est choisie dans le groupe des masses adhésives à base de caoutchouc naturel ou de synthèse, des masses adhésives de silicone, ainsi que notamment des masses adhésives de polyacrylate.

6. Procédé selon l'une quelconque des revendications précédentes,
**caractérisé en ce que** de l'air, du dioxyde de carbone, un gaz noble, de l'azote ou de l'oxygène ou des mélanges de ceux-ci sont utilisés en tant que gaz de processus pour le traitement par plasma.

7. Procédé selon la revendication 6,
**caractérisé en ce que** des substances gazeuses supplémentaires du groupe comprenant le siloxane, les acides acryliques ou les solvants ou l'hydrogène, les alcanes, les alcènes, les alcynes, le silane, les monomères organiques de silicium, les monomères d'acrylate, l'eau, les alcools, les peroxydes et les acides organiques sont incorporées dans le gaz de processus.

8. Dispositif comprenant
un milieu ayant une coupe transversale d'enroulement variable en termes d'une taille et
une bande adhésive enroulée sur elle-même autour du milieu le long de la coupe transversale d'enroulement, comprenant
un film support (1), sur un côté duquel est appliquée une couche de masse adhésive (2) et sur l'autre côté duquel est appliquée une couche d'agent antiadhésif traité par plasma (3).

9. Dispositif selon la revendication 8,
**caractérisé en ce que** la bande adhésive est collée en plusieurs couches d'enroulement les unes sur les autres.

10. Dispositif selon la revendication 8 ou 9, **caractérisé en ce que** la bande adhésive comprend au moins un filament, qui augmente la résistance à la traction.

11. Dispositif selon l'une quelconque des revendications 8, 9 ou 10,
**caractérisé en ce qu'**une pluralité de filaments est prévue dans la bande adhésive.

12. Dispositif selon l'une quelconque des revendications 8 à 11,
**caractérisé en ce qu'**un agent antiadhésif de la couche d'agent antiadhésif (3) provient du groupe comprenant :
les systèmes de séparation tensioactifs à base de groupes alkyle à chaîne longue tels que les sulfosuccinates de stéaryle ou les sulfosuccinamates de stéaryle ; les polymères qui peuvent être du groupe constitué par les carbamates de polyvinylstéaryle, les polyéthylène-imine-stéarylcarbamides, les complexes de chrome d'acides gras en C14 à C28 et les copolymères de stéaryle, ou à base de polymères acryliques dotés de groupes alkyle perfluorés ; les silicones ou les composés de fluorosilicone, notamment à base de poly(diméthyl-)siloxanes.

13. Dispositif selon l'une quelconque des revendications 8 à 12,
**caractérisé en ce qu'**une masse adhésive de la couche de masse adhésive (2) provient du groupe des masses adhésives à base de caoutchouc naturel ou de synthèse, des masses adhésives de silicone, ainsi que notamment des masses adhésives de polyacrylate.
